Europäisches Patentamt

European Patent Office

Office européen des brevets

(11) Publication number: **0 145 327**
**B1**

# EUROPEAN PATENT SPECIFICATION

(45) Date of publication of patent specification: **03.08.88**

(51) Int. Cl.⁴: **H 05 K 7/02**

(21) Application number: **84307904.7**

(22) Date of filing: **14.11.84**

(54) Electrical interface arrangement.

(30) Priority: **24.10.84 GB 8426926**
**15.11.83 GB 8330391**

(43) Date of publication of application:
**19.06.85 Bulletin 85/25**

(45) Publication of the grant of the patent:
**03.08.88 Bulletin 88/31**

(84) Designated Contracting States:
**AT BE CH DE FR IT LI LU NL SE**

(56) References cited:
**WO-A-83/00585**
**FR-A-2 288 394**
**US-A-4 008 300**

(73) Proprietor: **The General Electric Company, p.l.c.**
**1 Stanhope Gate**
**London W1A 1EH (GB)**

(72) Inventor: **Heard, Maurice Clifford**
**Sherridan Lodge 40, Elm Grove**
**Hullbridge Essex (GB)**

(74) Representative: **Hoste, Colin Francis**
**The General Electric Company p.l.c. Central**
**Patent Department (Wembley Office) Hirst**
**Research Centre East Lane**
**Wembley Middlesex, HA9 7PP (GB)**

Courier Press, Leamington Spa, England.

## Description

This invention relates to an electrical interface arrangement as claimed in the prior art portion of claim 1. Such an arrangement is known from FR-A-2 288 394. By means of such an arrangement a very small electrical component can be held in position as part of an electrical circuit from which it can be readily extracted, if the need should arise, without damage either to itself or the circuit of which it forms a part. The invention is particularly suitable for providing electrical connection between very small complex integrated circuit components and larger circuits which are sometimes termed hybrid microcircuits, the latter typically comprising a ceramic substrate carrying one or several layers of conductive inter-connection tracks and other circuit components.

Typically, the integrated circuits are mounted in an "unpackaged" state on to the hybrid microcircuit; that is to say, the semiconductor chip, usually silicon, which comprises an integrated circuit is not first mounted in its own hermetically sealed housing, but instead the chip is bonded directly to the surface of the hybrid microcircuit. Electrical connection is usually made by means of many individual fine gold wires bonded between corresponding terminal points on the integrated circuit and the hybrid microcircuit.

If it is desired to remove and replace an electrical component, it is difficult to achieve without causing some damage, and in any event it is a time consuming and skilled task.

The present invention seeks to provide an improved electrical interface arrangement in which such difficulties are reduced.

The electrical interface arrangement according to the present invention is characterized in that the housing member is formed of a resiliently deformable compliant material.

Although the interface arrangement is very suitable for mounting semiconductor chips on to the ceramic substrate of a hybrid circuit, its use is not confined to this purpose. A larger interface arrangement will represent a satisfactory way of forming electrical connections to larger, more conventional components.

The invention is further described by way of example with reference to the accompanying drawings, in which:

Figure 1 shows a plan perspective view of an interface arrangement in accordance with the invention.

Figure 2 shows a sectional view through such an arrangement, and

Figure 3 shows an alternative form of an electrical interface arrangement.

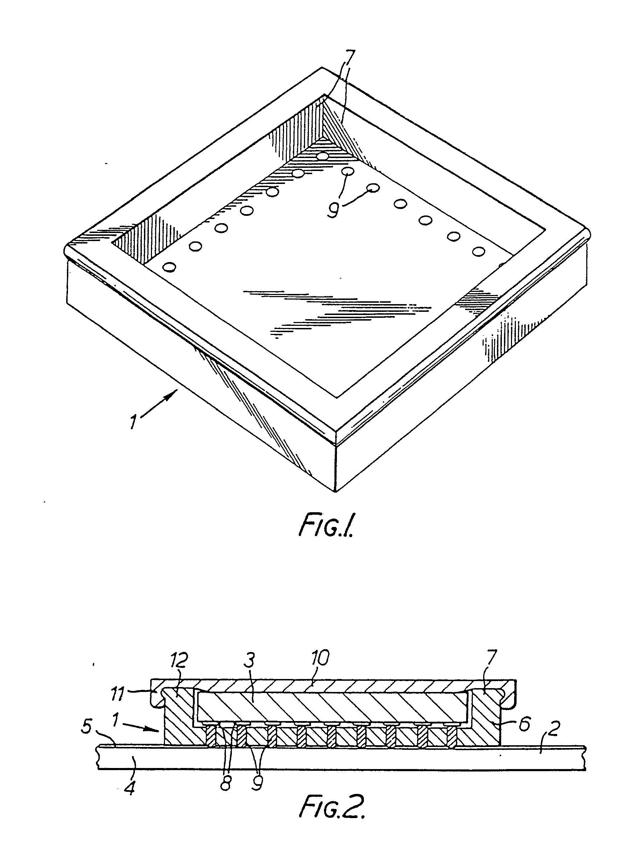

Referring to Figure 1 and 2, an electrical interface arrangement is mounted upon the upper surface of a hybrid microcircuit 2 (not shown in Figure 1) and contains a small electronic component in the form of an integrated circuit 3. The integrated circuit is typically a device which is generally termed an electrically programmable read only memory (EPROM). Such devices are becoming increasingly common and it is necessary to enter particular data into the memory region of such a device using a special instrument. The advantage of such a memory is that its contents can be readily and rapidly erased if it is desired to change the stored data. Subsequent to the erasure, the new information is entered from one of the dedicated instruments which have been designed for this purpose. Typically, EPROM devices are used to store data which can form part of a software programme, and thus it may contain information which is not altered frequently and indeed, may never be altered. However, a change in the software programme of the circuit of which the EPROM forms a part, necessitates the removal of the EPROM from that circuit so that it can be reprogrammed using the dedicated instrument referred to previously.

Instead of an EPROM, the electronic component could be some other kind of device, such as a programmable logic array (PLA), which is an array of various logic gates which can be configured, after manufacture, into a particular circuit function. This configuration is facilitated by being able to easily remove and replace the device using the interface arrangement of this invention.

The hybrid microcircuit 2 is of a kind of circuit which is becoming increasingly common. It comprises, in essence, a ceramic substrate 4 which carries a number of layers 5 of interconnection tracks. The interconnection tracks typically consist of gold or copper which are separated by thin layers of electrically insulating glass, but these layers are indicated diagramatically in the drawings by the single layer 5. In this way, very large and complex circuits can be realised in a very permanent and economical manner. Although in terms of circuit functions the circuits may be regarded as being large, they are physically very small, typically not more than a few centimetres square. When the hybrid microcircuit has been manufactured to completion it is mounted in its own package which is hermetically sealed and which is provided with terminals which enable the circuit to be interconnected with other larger circuits as required. It is because it is necessary to encapsulate the hybrid microcircuit as a whole that the individual integrated circuit 3 can be mounted in an unpackaged form. A typical dimension for an electronic component such as an integrated circuit 3 EPROM is 4,57mm (180 × 10⁻³ inches) wide, 6,09mm (240 × 10⁻³ inches) high and 0,25mm (10 × 10⁻³ inches) thick. It will be appreciated therefore that such a device is extremely small and difficult to handle.

The integrated circuit 3 is secured to the hybrid microcircuit 2 by means of the electrical interface arrangement 1 which consists essentially of a housing 6 formed of a resiliently deformable compliant material, for example rubber, or an elastomer, such as a silicone or fluoro-silicone rubber. The housing 6 is formed of an elastomer which is an insulating material and it is shaped in the form of an open rectangular container having walls 7 which locate the outer perimeter of the integrated circuit 3. In practice, the nominal dimensions of the integrated circuit 3 will vary markedly, due to manufacturing tolerances on the origin of the source of supply. The compliance of the elastomer permits the interface arrangement to accept components whose physical dimensions vary over quite a wide range, and typically a range of up to 15% linear dimensions is quite acceptable.

The integrated circuit 3 contains small contact pads 8 on its lower surface. These pads are arranged in a regular array around the perimeter of the underside and serve to make electrical connection with the integrated circuit itself. These contact pads co-operate with an array of contact pins 9 which extend through the base of the housing 6 so as to protrude slightly at each end and make electrical contact to the conductive tracks at the layer 5 on the surface of the hybrid microcircuit. These conductive pins 9 are also formed of an elastomer, but in this case a conductive material. Such materials are readily available and can be manufactured to finely determined tolerances.

The elastomer of which the housing is formed is a homogenous material, and a suitable material is that produced by Dow Corning under the name Silastic, type E, which is a room temperature vulcanizing silicone rubber. It is initially a pourable fluid, which is reduced to low pressure to remove air from it, and is poured into a mould to set. The elastomer of which the pins 9 are formed can be the same basic material, but to which is added a quantity of very fine conductive metallic powder, e.g. gold, before the fluid rubber is deaerated. Uniform distribution of the powder is achieved by agitating the fluid ultrasonically. It is then poured into suitable moulds where it sets into the required shapes. The use of such a material gives good compliance properties, and also electrically conductive properties which are not dependent on the direction in which the pins are distorted in use.

As an elastomer is a resiliently deformable material with bulk compliance properties it is possible to manufacture the pins so that they have a nominal diameter which is slightly larger than the holes which are initially formed in the housing 6. Thus, when the pins are pressed into these apertures, they are retained firmly in position by the force which is exerted upon them due to the resilience of the elastomer.

The electronic component is held firmly in position by means of a top cap 10 (omitted in Figure 1) which has an outer rim 11 which snaps over a protruding lip 12 at the top of the housing 6. This snap action secures the cap 10 firmly in a position in which its underside surface bears firmly against the top of the electronic component, thereby urging the contact pads 8 into good electrical connection with the conductive pins 9. The diameters of the pins 9 are chosen so as to permit a certain degree of positional mismatch with the conductive pads 8 so as to accommodate variations in physical sizes of the electronic component.

The housing 6 is attached to the surface of the microcircuit 2 by means of an adhesive, although a mechanical clamp could be used. The lower protruding ends of the pins 9 are thereby held in pressure contact with the conductive tracks on the upper surface of the microcircuit 2.

It will be appreciated that an electronic component 3 can be readily inserted into the interface arrangement and subsequently removed without causing any damage, either to itself or to the hybrid circuit on which it is mounted. The task is a simple one and does not require any excessive time or skill on the part of an operator. In addition, the physical dimensions of the interface arrangement are not very much greater than those of the electronic component itself and are certainly very much less than the normal package in which individual integrated circuits are provided when each is mounted in an individual hermetically sealed container.

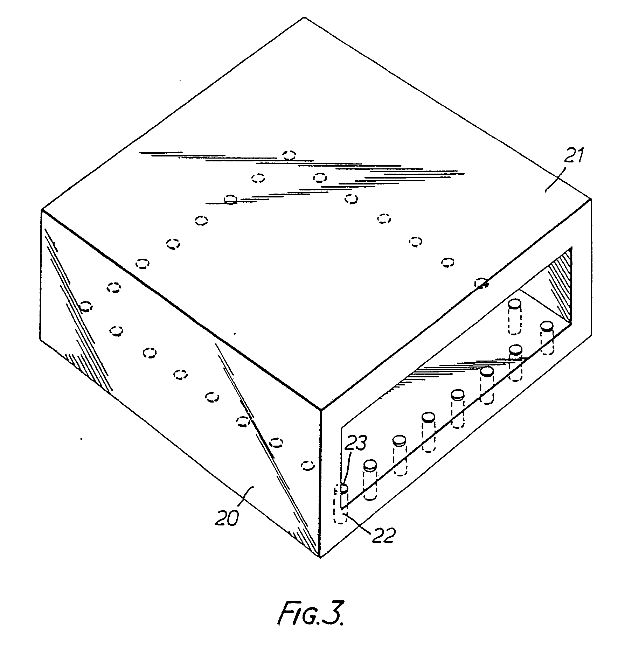

An alternative form of electrical interface arrangement is illustrated in Figure 3 in which a housing 20 is formed of an electrically insulating elastomer material. It incorporates not only the base and side walls, but also a roof cap 21 which is formed integrally therewith. As before, individual conductive pins 22 are formed in the base of the housing 20 and their ends 23 protrude slightly above the internal floor surface so as to permit electrical contact with an array of surface pads on the underside of an electronic component. The pins 22 are composed of an electrically conductive elastomer. The electronic component, typically in the form of an integrated circuit chip, is passed through a slot opening 24 in one wall of the housing 20. The resilience of the materials involved enables the components to be pushed into the housing fairly readily over the slightly raised ends 23 of the conducting pins 22 and also secures the circuit component firmly in position. It can however, readily be removed should the need arise, by means of a suitable tool such as nonconductive tweezers or pincers, or alternatively, an additional slot can be positioned in the wall opposite to slot opening 24 so that the component can be simply ejected.

**Claims**

1. An electrical interface arrangement for an electrical device (3), the electrical device having an array of electrical terminal pads (8), said arrangement including an insulating housing member (6) having a base portion, wall regions extending from the base portion and an array of contacts (9) each of which is formed of a resiliently deformable electrical conductive compliant material, the contacts being in the form of elongate members extending through the thickness of the base portion so as to protrude from opposing surfaces thereof, said housing member locating the electrical device so as to align its terminal pads (8) with the contacts (9), said arrangement being characterized in that the housing member is formed of a resiliently deformable compliant material.

2. An arrangement as claimed in claim 1 and wherein the contacts are positioned around the edges of the base region and take the form of elongate pins extending through the thickness of the base.

3. An arrangement as claimed in claim 1 or 2 and wherein means comprising resiliently deformable compliant material is positioned so as to urge said device against said array of contacts.

4. An arrangement as claimed in claim 3 and wherein said means comprises a roof portion formed integrally with said housing member.

5. An arrangement as claimed in claim 3 and wherein said means comprises a detachable lid of said housing member.

6. An arrangement as claimed in any of the preceding claims and wherein the compliant material is of a homogenous nature.

**Patentansprüche**

1. Elektrische Interfaceanordnung für eine elektrische Vorrichtung (3), welche elektrische Vorrichtung eine Gruppierung elektrischer Anschlußflächen (8) aufweist, wobei die Anordnung ein isolierendes Gehäuseteil (6) einschließt, das einen Basisbereich, sich vom Basisbereich erstreckende Wandbereiche und eine Gruppierung von Kontakten (9) aufweist, von denen jeder aus elastisch deformierbarem, elektrisch leitfähigem, nachgiebigem Material gebildet ist, wobei die Kontakte die Form länglicher, sich durch die Dicke des Basisbereichs derart erstrekender Glieder aufweisen, daß sie aus dessen entgegengesetzten Oberflächen herausragen, wobei das Gehäuseteil die elektrische Vorrichtung derart eingrenzt, daß deren Anschlußflächen (8) mit den Kontakten (9) ausgerichtet werden, welche Anordnung dadurch gekennzeichnet ist, daß das Gehäuseteil aus einem elastisch deformierbaren nachgiebigen Material gebildet ist.

2. Anordnung nach Anspruch 1 und in welcher die Kontakte um die Ränder des Basisbereichs herum angeordnet sind und die Form sich durch die Dicke der Basis erstreckender länglicher Stifte annehmen.

3. Anordnung nach Anspruch 1 oder 2 und in welcher eine Einrichtung, die elastisch deformierbares nachgiebiges Material aufweist, so positioniert ist, daß sie diese Vorrichtung gegen die Gruppierung von Kontakten drängt.

4. Anordnung nach Anspruch 3 und in welcher diese Einrichtung einen integral mit dem Gehäuseteil ausgebildeten Abdeckungsbereich aufweist.

5. Anordnung nach Anspruch 3 und in welcher diese Einrichtung einen abnehmbaren Deckel des Gehäuseteils umfaßt.

6. Anordnung nach einem der vorhergehenden Ansprüche und in welcher das nachgiebige Material homogener Natur ist.

**Revendications**

1. Elément d'interface électrique destiné à un dispositif électrique (3), le dispositif électrique ayant un arrangement de plages (8) formant des bornes électriques, l'élément comprenant un organe isolant (6) de boîtier qui a une partie de base, des régions de paroi partant de la partie de base et un arrangement de contacts (9) formés chacun d'un matériau souple, conducteur de l'électricité et élastiquement déformable, les contacts étant sous forme d'organes allongés traversant la partie de base suivant l'épaisseur afin qu'elle dépasse de surfaces opposées de cette partie de base, l'organe de boîtier assurant le positionnement du dispositif électrique afin que ses plages (8) de bornes soient alignées sur les contacts (9), l'élément étant caractérisé en ce que l'organe du boîtier est formé d'un matériau souple élastiquement déformable.

2. Elément selon la revendication 1, dans lequel les contacts sont placés autour des bords de la région de base et sont sous forme de broches allongées traversant la base dans la direction de l'épaisseur.

3. Elément selon l'une des revendications 1 et 2, dans lequel un dispositif constitué d'un matériau souple et élastiquement déformable est disposé de manière qu'il repousse le dispositif contre l'arrangement de contacts.

4. Elément selon la revendication 3, dans lequel ledit dispositif a une partie en forme de toit qui est réalisée sous forme solidaire de l'organe du boîtier.

5. Elément selon la revendication 3, dans lequel ledit dispositif comprend un couvercle amovible de l'organe du boîtier.

6. Elément selon l'une quelconque des revendications précédentes, dans lequel le matériau souple a une nature homogène.

0 145 327

Fig. I.

Fig. 2.

1

FIG.3.

2